# EUROPÄISCHE PATENTANMELDUNG

(11) **EP 4 517 812 A2**
(43) Veröffentlichungstag der Anmeldung: **05.03.2025**
(21) Anmeldenummer: 24196322.2
(22) Anmeldetag: 23.08.2024
(51) Int. Cl.: H01L 23/36

(54) **HAUSHALTSGERÄTEVORRICHTUNG, HAUSHALTSGERÄT UND VERFAHREN ZUR HERSTELLUNG DER HAUSHALTSGERÄTEVORRICHTUNG**

(30) Priorität: 04.09.2023 EP 23382894
(71) Anmelder: BSH Hausgeräte GmbH, 81739 München (DE)
(72) Erfinder: Cabeza Gozalo, Tomas, 50010 Zaragoza (ES); Fernandez Martinez, Manuel, 50006 Zaragoza (ES); Hernandez Blasco, Pablo Jesus, 50019 Zaragoza (ES); Aranda Vazquez, Sandra, 50018 Zaragoza (ES); Felices Betran, Jorge, 22003 Huesca (Spain) (ES)

(57) **Zusammenfassung**

Um eine Haushaltsgerätevorrichtung mit verbesserten Eigenschaften hinsichtlich einer Kühlung, einer Herstellung und Montage, mechanischer Toleranzen und/oder Materialanforderungen zur Verfügung zu stellen, wird eine gattungsgemäße Haushaltsvorrichtung (10) mit einem ersten SMD-Bauelement (12), zumindest einem zweiten SMD-Bauelement (14) und einer Wärmeverteilungsplatte (16), welche auf einer ersten Oberseite (18) des ersten SMD-Bauelements (12) und auf einer zweiten Oberseite (20) des zweiten SMD-Bauelements (14) angeordnet ist, vorgeschlagen.

## Beschreibung

### Stand der Technik

Die Erfindung betrifft eine Haushaltsgerätevorrichtung.

Aus dem Stand der Technik sind Haushaltegerätevorrichtungen mit mittels Durchsteckmontage montierten elektronischen Bauelementen bekannt. Außerdem sind oberflächenmontierte Bauelemente mit einer Kombination von unterseitiger Kühlung und isolierten Metallsubstraten bekannt, welche jedoch komplexe Leiterbahnen im Metallsubstrat erfordern und im Allgemeinen hohe Kosten aufweisen. Ferner sind oberflächenmontierte Bauelemente mit oberseitiger Kühlung bekannt, wobei im Allgemeinen diesbezüglich keine Materialien bekannt sind, deren elektrische, thermische und/oder Kompressionseigenschaften gleichzeitig gut und kostengünstig sind.

Die Aufgabe der Erfindung besteht insbesondere, aber nicht beschränkt darauf, darin, eine gattungsgemäße Vorrichtung mit verbesserten Eigenschaften hinsichtlich einer Kühlung, einer Herstellung und Montage, mechanischer Toleranzen und/oder Materialanforderungen bezüglich einer elektrischen Isolierung bereitzustellen. Die Aufgabe wird erfindungsgemäß durch die Merkmale des Anspruchs 1 gelöst, während vorteilhafte Ausgestaltungen und Weiterbildungen der Erfindung den Unteransprüchen entnommen werden können.

### Vorteile der Erfindung

Es wird eine Haushaltsgerätevorrichtung mit einem ersten SMD-Bauelement, zumindest einem zweiten SMD-Bauelement und einer Wärmeverteilungsplatte, welche auf einer ersten Oberseite des ersten SMD-Bauelements und auf einer zweiten Oberseite des zweiten SMD-Bauelements angeordnet ist, vorgeschlagen.

Durch eine derartige Ausgestaltung kann eine besonders große Wärmeaustauschfläche realisiert werden. Vorteilhaft kann ein Wärmewiderstand zwischen den SMD-Bauelementen und der Wärmeverteilungsplatte reduziert werden. Es kann eine schnelle und/oder zuverlässige Herstellung und Montage der Haushaltsgerätevorrichtung ermöglicht werden. Vorteilhaft kann eine besonders kostengünstige Herstellung erreicht werden.

Unter einer "Haushaltsgerätevorrichtung", insbesondere unter einer "Gargerätevorrichtung", vorteilhaft unter einer "Kochfeldvorrichtung" und besonders vorteilhaft unter einer "Induktionskochfeldvorrichtung" soll insbesondere zumindest ein Teil, insbesondere eine Unterbaugruppe, eines Haushaltsgeräts, insbesondere eines Gargeräts, vorteilhaft eines Kochfelds und besonders vorteilhaft eines Induktionskochfelds, verstanden werden. Beispielsweise könnte es sich bei einem die Haushaltsgerätevorrichtung aufweisenden Haushaltsgerät um eine Kühltruhe und vorteilhaft um einen Kühl- und/oder Gefrierschrank handeln. Ein die Haushaltsgerätevorrichtung aufweisendes Haushaltsgerät könnte alternativ oder zusätzlich beispielsweise eine Spülmaschine und/oder eine Waschmaschine und/oder ein Trockner sein. Vorteilhaft handelt es sich bei einem die Haushaltsgerätevorrichtung aufweisenden Haushaltsgerät um ein Gargerät. Ein als Gargerät ausgebildetes Haushaltsgerät könnte beispielsweise ein Backofen und/oder eine Mikrowelle und/oder ein Grillgerät und/oder ein Dampfgargerät sein. Vorteilhaft ist ein als Gargerät ausgebildetes Haushaltsgerät ein Kochfeld und vorzugsweise ein Induktionskochfeld.

Unter einem "SMD-Bauelement" soll insbesondere ein oberflächenmontiertes elektronisches Bauelement verstanden werden, welches vorzugsweise frei von Drahtanschlüssen ist und bevorzugt mittels lötfähiger Anschlussflächen oder -beinchen auf eine Leiterplatte lötbar ist. Das erste SMD-Bauelement und das zumindest eine zweite SMD-Bauelement sind insbesondere zu einer oberseitigen Kühlung vorgesehen, vorzugsweise ausgebildet. Unter "vorgesehen" soll speziell eingerichtet, speziell ausgelegt und/oder speziell ausgestattet verstanden werden. Darunter, dass ein Objekt zu einer bestimmten Funktion vorgesehen ist, soll verstanden werden, dass das Objekt diese bestimmte Funktion in zumindest einem Anwendungs- und/oder Betriebszustand erfüllt und/oder ausführt. Die SMD-Bauelemente weisen vorzugsweise auf ihrer Oberseite ein Kühlungspad auf. Das Kühlungspad ist insbesondere zu einem Wärmetransport von dem jeweiligen SMD-Bauelement zu der Wärmeverteilungsplatte vorgesehen. Es ist denkbar, dass das Kühlungspad zum Erfüllen einer elektrischen Funktion vorgesehen ist, beispielsweise mit einem Geräteanschluss verbunden ist oder zur elektrischen Isolierung vorgesehen ist.

Das erste SMD-Bauelement weist insbesondere eine Montageseite auf. Die Montageseite entspricht vorzugsweise einer Seite des ersten SMD-Bauelements, welche der Leiterplatte in einem auf der Leitplatte montierten Zustand zugewandt ist. Auf der Montageseite ist das erste SMD-Bauelement vorzugsweise mit der Leiterplatte verbunden. Die erste Oberseite des ersten SMD-Bauelements befindet sich auf einer zu der Montageseite abgewandten Seite des ersten SMD-Bauelements. Die erste Oberseite des ersten SMD-Bauelements ist auf einer zu der Leiterplatte abgewandten Seite des ersten SMD-Bauelements angeordnet. Die Ausführungen dieses Absatzes zum ersten SMD-Bauelement sind insbesondere analog auf das zweite SMD-Bauelement und vorzugsweise auf die zweite Oberseite des zweiten SMD-Bauelements zu lesen. Die erste Oberseite des ersten SMD-Bauelements ist insbesondere analog zu der zweiten Oberseite des zweiten SMD-Bauelements zu verstehend.

Vorzugsweise ist die Leiterplatte Teil der Haushaltsgerätevorrichtung. Die Leiterplatte ist bevorzugt aus einem FR4-Verbundwerkstoff, insbesondere aus Epoxidharz und Glasfasergewebe, ausgebildet. Alternativ ist jedoch auch denkbar, dass die Leiterplatte aus einem anderen, einem Fachmann als sinnvoll erscheinenden Material hergestellt ist.

Die Wärmeverteilungsplatte ist bevorzugt aus einem metallischen Material, beispielsweise aus Aluminium, Kupfer, Messing oder dergleichen. Eine Dicke der Wärmeverteilungsplatte beträgt bevorzugt zwischen 0,1 mm und 25 mm. Alternativ ist jedoch auch denkbar, dass die Dicke der Wärmeverteilungsplatte kleiner ist als 0,1 mm oder größer ist als 25 mm. Die Wärmeverteilungsplatte überdeckt insbesondere das erste SMD-Bauelement und das zweite SMD-Bauelement, vorzugweise zumindest in einer zu einer Haupterstreckungsebene der Wärmeverteilungsplatte senkrechten Richtung betrachtet. Unter einer "Haupterstreckungsebene" einer Baueinheit oder eines Elements kann eine Ebene verstanden werden, welche parallel zu einer größten Seitenfläche eines kleinstmöglichen gedachten Quaders ist, welcher die Baueinheit gerade noch vollständig umschließt, und insbesondere durch den Mittelpunkt des Quaders verläuft. Die Wärmeverteilungsplatte ist insbesondere zumindest im Wesentlichen plattenförmig , bevorzugt plattenförmig, ausgebildet. Darunter, dass ein Objekt "zumindest im Wesentlichen plattenförmig" ausgestaltet ist, soll insbesondere verstanden werden, dass zumindest ein kleinstmöglicher geometrischer Quader, welcher das Objekt gerade noch vollständig umschließt, plattenförmig ist. Darunter, dass ein Objekt "plattenförmig" ausgestaltet ist, soll insbesondere ein räumliches Objekt verstanden werden, das, in einer Abwicklung in einer Ebene betrachtet, in einem Querschnitt senkrecht zur Ebene eine unrunde Querschnittsfläche aufweist und senkrecht zur Ebene eine insbesondere zumindest im Wesentlichen gleichbleibende Materialstärke aufweist, die weniger als 50 %, vorzugsweise weniger als 25 % und besonders bevorzugt weniger als 10 % einer Flächenerstreckung des räumlichen Elements parallel zur Ebene, insbesondere einer kleinsten Flächenerstreckung des Elements parallel zur Ebene, beträgt.

Außerdem wird vorgeschlagen, dass die Haushaltsgerätevorrichtung zumindest eine dielektrische Schicht aufweist, welche zwischen der Wärmeverteilungsplatte und der ersten Oberseite des ersten SMD-Bauelements und der zweiten Oberseite des zweiten SMD-Bauelements angeordnet ist. Vorteilhaft können die elektrischen Isolationsanforderungen einer thermischen Schnittstelle zwischen Wärmeverteilungsplatte und den SMD-Bauelementen gering gehalten werden. Vorteilhaft kann ein Volumen eines, insbesondere zwischen den SMD-Bauelementen und der Wärmeverteilungsplatte anordenbaren und zu einer Wärmeleitung vorgesehenen, Spaltfüllmaterials besonders gering gehalten werden. Vorteilhaft kann eine besonders große Flexibilität bezüglich einer Art des Spaltfüllmaterials erreicht werden. Es kann auch ein Spaltfüllmaterial mit geringer elektrischer Isolierung und besonders guten thermischen Eigenschaften, wie beispielsweise Wärmeleitpaste, verwendet werden. Die dielektrische Schicht kann aus einem oder mehreren Materialien ausgebildet sein. Eine den SMD-Bauelementen und/oder der Leiterplatte zugewandte Oberfläche der Wärmeverteilungsplatte ist vorzugsweise zumindest im Wesentlichen vollständig von der dielektrischen Schicht überdeckt. Unter "zumindest im Wesentlichen vollständig" soll insbesondere zu zumindest 50 %, vorzugsweise zu zumindest 75 %, bevorzugt zu zumindest 90 % und besonders bevorzugt zu zumindest 99 % verstanden werden. Alternativ ist jedoch auch denkbar, dass die Haushaltsgerätevorrichtung frei von einer dielektrischen Schicht ausgebildet ist, insbesondere wenn die SMD-Bauelemente an ihrer Oberseite elektrisch isolierend ausgebildet sind.

Zudem wird vorgeschlagen, dass die Haushaltsgerätevorrichtung zumindest ein Befestigungselement aufweist, welches zwischen der Wärmeverteilungsplatte und der ersten Oberseite des ersten SMD-Bauelements und/oder der zweiten Oberseite des zweiten SMD-Bauelements angeordnet ist. Vorteilhaft kann ein besonders zuverlässiger und/oder effektiver Wärmetransport realisiert werden. Die dielektrische Schicht ist vorzugsweise zwischen der Wärmeverteilungsplatte und dem Befestigungselement angeordnet. Das Befestigungselement ist vorzugsweise zwischen der dielektrischen Schicht und dem ersten SMD-Bauelement und/oder dem zweiten SMD-Bauelement angeordnet. Bevorzugt ist jedem der SMD-Bauelemente jeweils ein Befestigungselement zugeordnet. Zumindest eines der SMD-Bauelemente ist an dem Befestigungselement befestigt, vorzugsweise verlötet. Insbesondere ist zumindest eines der SMD-Bauelemente, abgesehen von einer Lötpaste, unmittelbar an dem Befestigungselement anliegend angeordnet. Das Befestigungselement ist vorzugsweise an der dielektrischen Schicht befestigt, insbesondere unmittelbar. Eine Dicke des Befestigungselements liegt vorzugsweise im Mikrometerbereich. Bevorzugt bilden das zumindest eine Befestigungselement, die dielektrische Schicht und die Wärmeverteilungsplatte ein isoliertes Metallsubstrat.

Des Weiteren wird vorgeschlagen, dass das Befestigungselement zumindest ein elektrisches Verbindungselement und/oder zumindest ein Schaltungselement aufweist. Vorteilhaft kann das Befestigungselement verschiedene Funktionen erfüllen. Es kann eine besonders hohe Flexibilität beim Aufbau der Haushaltsgerätevorrichtung realisiert werden. Vorteilhaft kann die Haushaltsgerätevorrichtung besonders kompakt aufgebaut werden. Ein elektrische Verbindungselement ist vorzugsweise als eine Leiterbahn oder dergleichen ausgebildet. Es ist denkbar, dass das elektrische Verbindungselement zur Verbindung von zwei elektronischen Bauelementen vorgesehen ist. Ein Schaltungselement kann beispielsweise ein elektrisches, insbesondere elektronisches, Bauelement und/oder zumindest ein Teil einer elektrischen, insbesondere elektronischen, Schaltung sein. Es ist denkbar, dass das zumindest eine Befestigungselement zumindest einen Teil einer Schaltung zur Überwachung einer Temperatur der Wärmeverteilungsplatte aufweist, beispielsweise durch Einlöten eines Thermistors, vorzugsweise eines Heißleiters.

Ferner wird vorgeschlagen, dass die Wärmeverteilungsplatte zumindest ein elektrisches Verbindungselement und/oder Schaltungselement aufweist. Vorteilhaft kann die Wärmeverteilungsplatte verschiedene Funktionen erfüllen. Es kann eine besonders hohe Flexibilität beim Aufbau der Haushaltsgerätevorrichtung realisiert werden. Vorteilhaft kann die Haushaltsgerätevorrichtung besonders kompakt aufgebaut werden.

Weiterhin wird vorgeschlagen, dass die Haushaltsgerätevorrichtung zumindest ein Spaltfüllelement aufweist, welches auf einer zu dem ersten SMD-Bauelements und dem zweiten SMD-Bauelement abgewandten Seite der Wärmeverteilungsplatte angeordnet ist. Vorteilhaft kann ein besonders effizienter Wärmetransport von der Wärmeverteilungsplatte an ein an dem Spaltfüllelement angeordnetes Element, vorzugsweise an einen Kühlkörper, realisiert werden. Es kann vorteilhaft eine besonders effiziente Kühlung der Haushaltsgerätevorrichtung erreicht werden. Die Haushaltsgerätevorrichtung weist vorzugsweise zumindest einen, insbesondere den zuvor bereits genannten, Kühlkörper auf. Der Kühlkörper ist vorzugsweise über das Spaltfüllelement an der Wärmeverteilungsplatte angeordnet, insbesondere befestigt. Bevorzugt erstreckt sich der Kühlkörper über zumindest einen Großteil der Wärmeverteilungsplatte, insbesondere über zumindest einen Großteil einer den SMD-Bauelementen abgewandten Oberfläche der Wärmeverteilungsplatte. Das Spaltfüllelement erstreckt sich vorzugsweise über zumindest einen Großteil der Wärmeverteilungsplatte, insbesondere über zumindest einen Großteil einer den SMD-Bauelementen abgewandten Oberfläche der Wärmeverteilungsplatte. Unter "zumindest einem Großteil" sollen insbesondere zumindest 50 %, vorzugsweise zumindest 75 %, bevorzugt zumindest 90 % und besonders bevorzugt zumindest 99 % verstanden werden. Das Spaltfüllelement ist insbesondere zu einem Wärmetransport zwischen zwei Elementen vorgesehen, hier vorzugsweise zwischen der Wärmeverteilungsplatte und dem Kühlkörper. Das Spaltfüllelement kann beispielsweise ein thermisches Fett, ein Isoliermaterial mit oder ohne Phasenwechsel oder dergleichen sein. Unter dem Spaltfüllelement ist insbesondere ein Gap-Filler zu verstehen, vorzugsweise ein weiches, elastisches Thermal Pad. Das Spaltfüllelement ist insbesondere auch dazu vorgesehen, mechanische Oberflächentoleranzen auszugleichen, beispielsweise Rauheit und/oder Höhendifferenzen. Es ist denkbar, dass das Spaltfüllelement aus einem kompressiblen und/oder elektrisch isolierenden Material ausgebildet ist.

Außerdem wird ein, insbesondere das zuvor bereits genannte, Haushaltsgerät mit einer erfindungsgemäßen Haushaltsgerätevorrichtung vorgeschlagen. Vorteilhaft kann ein Haushaltsgerät mit einer besonders effizient und/oder platzsparend kühlbaren Haushaltsgerätevorrichtung zur Verfügung gestellt werden. Vorteilhaft kann das Haushaltsgerät besonders kompakt ausgebildet werden. Es kann ein besonders zuverlässiger Betrieb des Haushaltsgeräts ermöglicht werden.

Zudem geht die Erfindung aus von einem Verfahren zur Herstellung einer, insbesondere der zuvor bereits genannten, Haushaltsgerätevorrichtung aus. Es wird vorgeschlagen, dass eine, insbesondere die zuvor bereits genannte, Wärmeverteilungsplatte auf einer, insbesondere der zuvor bereits genannten, ersten Oberseite eines, insbesondere des zuvor bereits genannten, ersten SMD-Bauelements und auf einer, insbesondere der zuvor bereits genannten, zweiten Oberseite eines, insbesondere des zuvor bereits genannten, zweiten SMD-Bauelements befestigt wird. Vorteilhaft kann eine besonders große Wärmeaustauschfläche realisiert werden. Vorteilhaft kann ein Wärmewiderstand zwischen den SMD-Bauelementen und der Wärmeverteilungsplatte reduziert werden. Es kann eine schnelle und/oder zuverlässige Herstellung und Montage der Haushaltsgerätevorrichtung ermöglicht werden. Vorteilhaft kann eine besonders kostengünstige Herstellung erreicht werden. Insbesondere wird die Wärmeverteilungsplatte über das zumindest eine Befestigungselement an der ersten Oberseite des ersten SMD-Bauelements und/oder an der zweiten Oberseite des zweiten SMD-Bauelements befestigt, bevorzugt mittels Lötpaste. Die Befestigung der Wärmeverteilungsplatte auf der ersten Oberseite des ersten SMD-Bauelements und auf der zweiten Oberseite des zweiten SMD-Bauelements erfolgt insbesondere mittels Lötverfahren, beispielsweise durch Wiederaufschmelzlöten mithilfe eines Reflow-Ofens.

Des Weiteren wird vorgeschlagen, dass das erste SMD-Bauelement und das zweite SMD-Bauelement mit der auf der ersten Oberseite und auf der zweiten Oberseite befestigten Wärmeverteilungsplatte auf einer, insbesondere der zuvor bereits genannten, Leiterplatte montiert werden. Vorteilhaft kann eine besonders einfache und/oder schnelle Montage auf der Leiterplatte erfolgen. Vorteilhaft können die Komponenten über die Wärmeverteilungsplatte bei einer Montage auf der Leiterplatte gekühlt werden. Vorteilhaft kann eine besonders zuverlässige Montage auf der Leiterplatte erreicht werden. Vorzugsweise werden das erste SMD-Bauelement und zumindest das zweite SMD-Bauelement durch ein Lötverfahren an der Leiterplatte montiert.

Ferner wird vorgeschlagen, dass auf einer dem ersten SMD-Bauelement und dem zweiten SMD-Bauelement abgewandten Seite der Wärmeverteilungsplatte zumindest ein, insbesondere der zuvor bereits genannte, Kühlkörper befestigt wird. Vorteilhaft kann ein besonders effizienter Wärmetransport von den SMD-Bauelementen zum Kühlkörper erreicht werden. Insbesondere wird auf der dem ersten SMD-Bauelement und dem zweiten SMD-Bauelement abgewandten Seite der Wärmeverteilungsplatte das Spaltfüllelement angebracht. Der Kühlkörper wird bevorzugt auf der dem ersten SMD-Bauelement und dem zweiten SMD-Bauelement abgewandten Seite der Wärmeverteilungsplatte an dem Spaltfüllelement befestigt, vorzugsweise auf einer zu der Wärmeverteilungsplatte abgewandten Seite des Spaltfüllelements. Alternativ ist auch denkbar, dass das erste SMD-Bauelement und zumindest das zweite SMD-Bauelement auf der Leiterplatte befestigt werden, vorzugsweise mittels Löten, und anschließend die Wärmeverteilungsplatte, insbesondere mit der dielektrischen Schicht und dem zumindest einen Befestigungselement, auf der ersten Oberseite des ersten SMD-Bauelements und auf der zweiten Oberseite des zweiten SMD-Bauelements befestigt werden, bevorzugt mittels Löten.

Die Haushaltsgerätevorrichtung, das Haushaltsgerät und/oder das Verfahren sollen/soll hierbei nicht auf die oben beschriebene Anwendung und Ausführungsform beschränkt sein. Insbesondere können/kann die Haushaltsgerätevorrichtung, das Haushaltsgerät und/oder das Verfahren zu einer Erfüllung einer hierin beschriebenen Funktionsweise eine von einer hierin genannten Anzahl von einzelnen Elementen, Bauteilen, Einheiten und Verfahrensschritten abweichende Anzahl aufweisen.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine Draufsicht auf ein erfindungsgemäßes Haushaltsgerät in einer schematischen Darstellung,

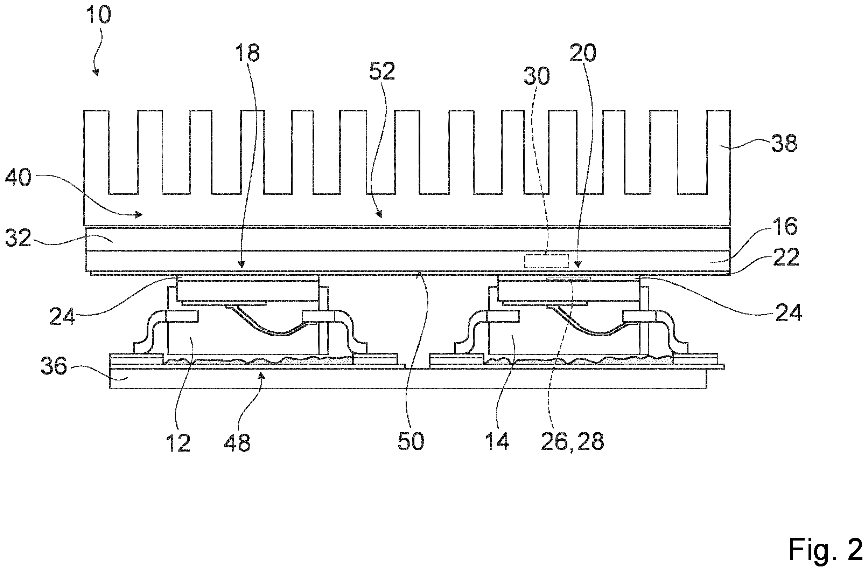

- Fig. 2: eine Haushaltsgerätevorrichtung des Haushaltsgeräts in einer Seitenansicht,
- Fig. 3: einen Teil der Haushaltsgerätevorrichtung in einem Verfahrensschritt eines Verfahrens zur Herstellung der Haushaltsgerätevorrichtung,
- Fig. 4: einen Teil der Haushaltsgerätevorrichtung in einem weiteren Verfahrensschritt des Verfahrens,
- Fig. 5: einen schematischen Ablauf des Verfahrens zur Herstellung der Haushaltsgerätevorrichtung.

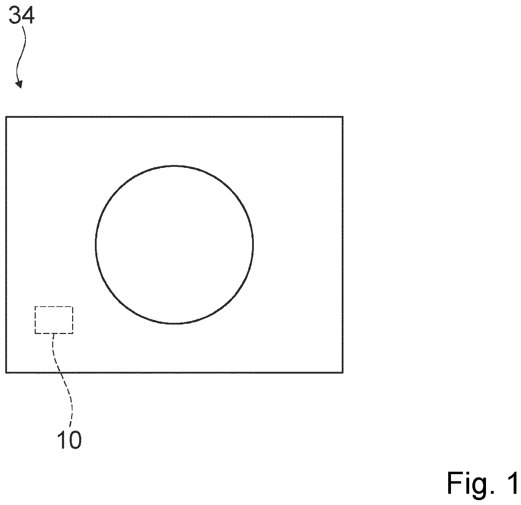

Figur 1 zeigt ein Haushaltsgerät 34. Das Haushaltsgerät 34 ist hier beispielhaft als Kochfeld, insbesondere als Induktionskochfeld, ausgebildet. Alternativ ist jedoch auch denkbar, dass das Haushaltsgerät 34 als eine Kühltruhe, als ein Kühl- und/oder Gefrierschrank, als eine Spülmaschine, als eine Waschmaschine, als ein Trockner oder als ein anderes, einem Fachmann als sinnvoll erscheinendes Haushaltsgerät 34 ausgebildet ist. Das Haushaltsgerät 34 weist eine Haushaltsgerätevorrichtung 10 auf.

Die Haushaltsgerätevorrichtung 10 weist ein erstes SMD-Bauelement 12 und ein zweites SMD-Bauelement 14 auf. Alternativ ist jedoch auch denkbar, dass die Haushaltsgerätevorrichtung 10 eine von zwei verschiedene Anzahl an SMD-Bauelementen 12, 14 aufweist, beispielsweise drei, vier, fünf oder mehr als fünf.

Die Haushaltsgerätevorrichtung 10 weist eine Leiterplatte 36 auf. Die Leiterplatte 36 ist aus einem FR4-Verbundwerkstoff, insbesondere aus Epoxidharz und Glasfasergewebe, ausgebildet. Alternativ ist jedoch auch denkbar, dass die Leiterplatte 36 aus einem anderen, einem Fachmann als sinnvoll erscheinenden Material hergestellt ist.

Das erste SMD-Bauelement 12 weist eine Montageseite 48 auf. Die Montageseite 48 entspricht einer Seite des ersten SMD-Bauelements 12, welche der Leiterplatte 36 in einem auf der Leitplatte 36 montierten Zustand zugewandt ist. Auf der Montageseite 48 ist das erste SMD-Bauelement 12 mit der Leiterplatte 36 verbunden. Eine erste Oberseite 18 des ersten SMD-Bauelements 12 befindet sich auf einer zu der Montageseite 48 abgewandten Seite des ersten SMD-Bauelements 12. Die erste Oberseite 18 des ersten SMD-Bauelements 12 ist auf einer zu der Leiterplatte 36 abgewandten Seite des ersten SMD-Bauelements 12 angeordnet. Die Ausführungen dieses Absatzes zum ersten SMD-Bauelement 12 sind analog auf das zweite SMD-Bauelement 14 und vorzugsweise auf eine zweite Oberseite 20 des zweiten SMD-Bauelements 14 zu lesen.

Die Haushaltsgerätevorrichtung 10 weist eine Wärmeverteilungsplatte 16 auf. Die Wärmeverteilungsplatte 16 ist aus einem metallischen Material, beispielsweise aus Aluminium, Kupfer, Messing oder dergleichen, ausgebildet.

Eine Dicke der Wärmeverteilungsplatte 16 beträgt hier beispielhaft zwischen 0,1 mm und 25 mm. Alternativ ist jedoch auch denkbar, dass die Dicke der Wärmeverteilungsplatte 16 kleiner ist als 0,1 mm oder größer ist als 25 mm. Die Wärmeverteilungsplatte 16 überdeckt das erste SMD-Bauelement 12 und das zweite SMD-Bauelement 14, vorzugweise zumindest in einer zu einer Haupterstreckungsebene (hier nicht dargestellt) der Wärmeverteilungsplatte 16 senkrechten Richtung betrachtet. Die Wärmeverteilungsplatte 16 ist plattenförmig ausgebildet.

Die Wärmeverteilungsplatte 16 ist auf der ersten Oberseite 18 des ersten SMD-Bauelements 12 und auf der zweiten Oberseite 20 des zweiten SMD-Bauelements 14 angeordnet.

Die Haushaltsgerätevorrichtung 10 weist zumindest eine dielektrische Schicht 22 auf. Die dielektrische Schicht 22 ist zwischen der Wärmeverteilungsplatte 16 und der ersten Oberseite 18 des ersten SMD-Bauelements 12 und der zweiten Oberseite 20 des zweiten SMD-Bauelements 14 angeordnet. Die dielektrische Schicht 22 kann aus einem oder mehreren Materialien ausgebildet sein. Eine den SMD-Bauelementen 12, 14 und/oder der Leiterplatte 36 zugewandte Oberfläche 50 der Wärmeverteilungsplatte 16 ist zumindest im Wesentlichen vollständig von der dielektrischen Schicht 22 überdeckt.

Die Haushaltsgerätevorrichtung 10 weist hier beispielhaft zwei Befestigungselemente 24 auf. Eines der Befestigungselemente 24 ist zwischen der Wärmeverteilungsplatte 16 und der ersten Oberseite 18 des ersten SMD-Bauelements 12 angeordnet. Ein weiteres der Befestigungselemente 24 ist zwischen der Wärmeverteilungsplatte 16 und der zweiten Oberseite 20 des zweiten SMD-Bauelements 14 angeordnet.

Die dielektrische Schicht 22 ist zwischen der Wärmeverteilungsplatte 16 und den Befestigungselementen 24 angeordnet. Das eine Befestigungselement 24 ist zwischen der dielektrischen Schicht 22 und dem ersten SMD-Bauelement 12 angeordnet. Das eine weitere Befestigungselement 24 ist zwischen der dielektrischen Schicht 22 und dem zweiten SMD-Bauelement 14 angeordnet. Bevorzugt ist jedem der SMD-Bauelemente 12, 14 jeweils ein Befestigungselement 24 zugeordnet. Die SMD-Bauelemente 12, 14 sind an jeweils einem der Befestigungselemente 24 befestigt, vorzugsweise verlötet.

Die SMD-Bauelemente 12, 14 sind, abgesehen von einer Lötpaste 54, unmittelbar an dem jeweiligen Befestigungselement 24 anliegend angeordnet. Die Befestigungselemente 24 sind an der dielektrischen Schicht 22 befestigt, insbesondere unmittelbar.

Zumindest eines der Befestigungselemente 24 weist zumindest ein elektrisches Verbindungselement 26 und/oder zumindest ein Schaltungselement 28 auf. Das elektrische Verbindungselement 26 ist als eine Leiterbahn oder dergleichen ausgebildet. Das Schaltungselement 28 kann beispielsweise ein elektrisches, insbesondere elektronisches, Bauelement und/oder zumindest ein Teil einer elektrischen, insbesondere elektronischen, Schaltung sein. Es ist denkbar, dass das zumindest eine Befestigungselement 24 zumindest einen Teil einer Schaltung zur Überwachung einer Temperatur der Wärmeverteilungsplatte 16 aufweist, beispielsweise durch Einlöten eines Thermistors, vorzugsweise eines Heißleiters. Es ist jedoch alternativ auch denkbar, dass die Befestigungselemente 24 frei sind von elektrischen Verbindungselementen 26 und/oder Schaltungselementen 28.

Die Wärmeverteilungsplatte 16 weist hier beispielhaft zumindest ein Schaltungselement 30 auf. Das Schaltungselement 30 kann beispielsweise ein elektrisches, insbesondere elektronisches, Bauelement und/oder zumindest ein Teil einer elektrischen, insbesondere elektronischen, Schaltung sein.

Die Haushaltsgerätevorrichtung 10 weist zumindest ein Spaltfüllelement 32 auf. Das Spaltfüllelement 32 ist zwischen der Wärmeverteilungsplatte 16 und der ersten Oberseite 18 des ersten SMD-Bauelements 12 und der zweiten Oberseite 20 des zweiten SMD-Bauelements 14 angeordnet. Das Spaltfüllelement 32 ist zu einem Wärmetransport zwischen zwei Elementen vorgesehen, hier vorzugsweise zwischen der Wärmeverteilungsplatte 16 und einem Kühlkörper 38. Das Spaltfüllelement 32 kann beispielsweise ein thermisches Fett, ein Isoliermaterial mit oder ohne Phasenwechsel oder dergleichen sein. Unter dem Spaltfüllelement 32 ist ein Gap-Filler zu verstehen, vorzugsweise ein weiches, elastisches Thermal Pad. Das Spaltfüllelement 32 ist dazu vorgesehen, mechanische Oberflächentoleranzen auszugleichen, beispielsweise Rauheit und/oder Höhendifferenzen. Es ist denkbar, dass das Spaltfüllelement 32 aus einem kompressiblen und/oder elektrisch isolierenden Material ausgebildet ist.

Die Haushaltsgerätevorrichtung 10 weist zumindest den einen Kühlkörper 38 auf. Der Kühlkörper 38 ist über das Spaltfüllelement 32 an der Wärmeverteilungsplatte 16 angeordnet, insbesondere befestigt. Der Kühlkörper 38 erstreckt sich über zumindest einen Großteil der Wärmeverteilungsplatte 16, insbesondere über zumindest einen Großteil einer den SMD-Bauelementen 12, 14 abgewandten Oberfläche 52 der Wärmeverteilungsplatte 16. Das Spaltfüllelement 32 erstreckt sich vorzugsweise über zumindest einen Großteil der Wärmeverteilungsplatte 16, insbesondere über zumindest einen Großteil einer den SMD-Bauelementen 12, 14 abgewandten Oberfläche 52 der Wärmeverteilungsplatte 16. Die Oberfläche 52 ist auf einer zu der Oberfläche 50 abgewandten Seite der Wärmeverteilungsplatte 16 angeordnet.

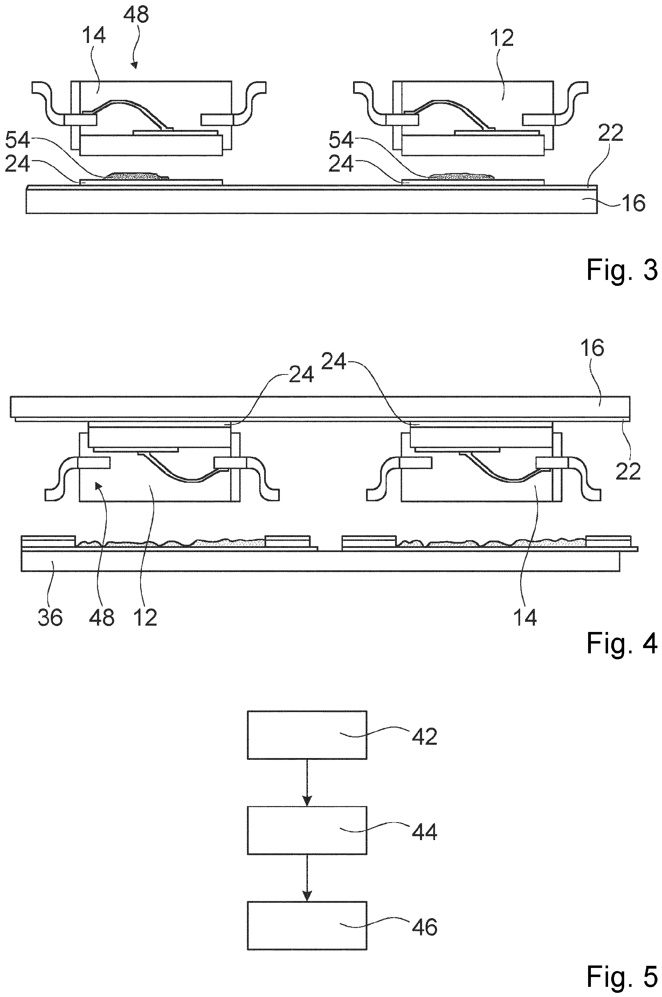

Figur 5 zeigt einen schematischen Ablauf eines Verfahrens zur Herstellung der Haushaltsgerätevorrichtung 10. In einem Verfahrensschritt 42 wird die Wärmeverteilungsplatte 16 auf der ersten Oberseite 18 des ersten SMD-Bauelements 12 und auf der zweiten Oberseite 20 des zweiten SMD-Bauelements 14 befestigt (vgl. insbesondere auch Figur 3).

Die Wärmeverteilungsplatte 16 wird über die Befestigungselemente 24 an der ersten Oberseite 18 des ersten SMD-Bauelements 12 und an der zweiten Oberseite 20 des zweiten SMD-Bauelements 14 befestigt, bevorzugt mittels Lötpaste 54. Die Befestigung der Wärmeverteilungsplatte 16 auf der ersten Oberseite 18 des ersten SMD-Bauelements 12 und auf der zweiten Oberseite 20 des zweiten SMD-Bauelements 14 erfolgt mittels Lötverfahren, beispielsweise durch Wiederaufschmelzlöten mithilfe eines Reflow-Ofens.

In einem weiteren Verfahrensschritt 44 werden das erste SMD-Bauelement 12 und das zweite SMD-Bauelement 14 mit der auf der ersten Oberseite 18 und auf der zweiten Oberseite 20 befestigten Wärmeverteilungsplatte 16 auf der Leiterplatte 36 montiert (vgl. insbesondere auch Figur 4). Das erste SMD-Bauelement 12 und das zweite SMD-Bauelement 14 werden durch ein Lötverfahren an der Leiterplatte 36 montiert.

In einem zusätzlichen Verfahrensschritt 46 wird auf einer dem ersten SMD-Bauelement 12 und dem zweiten SMD-Bauelement 14 abgewandten Seite 40 der Wärmeverteilungsplatte 16 das Spaltfüllelement 32 aufgebracht. In dem zusätzlichen Verfahrensschritt 46 wird auf der dem ersten SMD-Bauelement 12 und dem zweiten SMD-Bauelement 14 abgewandten Seite 40 der Wärmeverteilungsplatte 16 zumindest der Kühlkörper 38 befestigt, insbesondere auf dem Spaltfüllelement 32, vorzugsweise auf einer zu der Wärmeverteilungsplatte 16 abgewandten Seite des Spaltfüllelements 32. Figur 1 zeigt insbesondere den Zustand der Haushaltsgerätevorrichtung 10 nach dem Verfahrensschritt 46.

### Bezugszeichen

- 10: Haushaltsgerätevorrichtung
- 12: SMD-Bauelement
- 14: SMD-Bauelement
- 16: Wärmeverteilungsplatte
- 18: Oberseite
- 20: Oberseite
- 22: dielektrische Schicht
- 24: Befestigungselement
- 26: Verbindungselement
- 28: Schaltungselement
- 30: Schaltungselement
- 32: Spaltfüllelement
- 34: Haushaltsgerät
- 36: Leiterplatte
- 38: Kühlkörper
- 40: Seite
- 42: Verfahrensschritt
- 44: Verfahrensschritt
- 46: Verfahrensschritt
- 48: Montageseite
- 50: Oberfläche
- 52: Oberfläche
- 54: Lötpaste

## Patentansprüche

1. Haushaltsgerätevorrichtung (10) mit einem ersten SMD-Bauelement (12), zumindest einem zweiten SMD-Bauelement (14) und einer Wärmeverteilungsplatte (16), welche auf einer ersten Oberseite (18) des ersten SMD-Bauelements (12) und auf einer zweiten Oberseite (20) des zweiten SMD-Bauelements (14) angeordnet ist.

2. Haushaltsgerätevorrichtung (10) nach Anspruch 1, **gekennzeichnet durch** zumindest eine dielektrische Schicht (22), welche zwischen der Wärmeverteilungsplatte (16) und der ersten Oberseite (18) des ersten SMD-Bauelements (12) und der zweiten Oberseite (20) des zweiten SMD-Bauelements (14) angeordnet ist.

3. Haushaltsgerätevorrichtung nach Anspruch 1 oder 2, **gekennzeichnet durch** zumindest ein Befestigungselement (24), welches zwischen der Wärmeverteilungsplatte (16) und der ersten Oberseite (18) des ersten SMD-Bauelements (12) und/oder der zweiten Oberseite (20) des zweiten SMD-Bauelements (14) angeordnet ist.

4. Haushaltsgerätevorrichtung (10) nach Anspruch 3, **dadurch gekennzeichnet, dass** das Befestigungselement (24) zumindest ein elektrisches Verbindungselement (26) und/oder zumindest ein Schaltungselement (28) aufweist.

5. Haushaltsgerätevorrichtung (10) nach einem der vorhergehenden Ansprüche, **dadurch gekennzeichnet, dass** die Wärmeverteilungsplatte (16) zumindest ein Schaltungselement (30) aufweist.

6. Haushaltsgerätevorrichtung (10) nach einem der vorhergehenden Ansprüche, **gekennzeichnet durch** zumindest ein Spaltfüllelement (32), welches auf einer dem ersten SMD-Bauelement (12) und dem zweiten SMD-Bauelement (14) abgewandten Seite der Wärmeverteilungsplatte (16) angeordnet ist.

7. Haushaltsgerät (34) mit einer Haushaltsgerätevorrichtung (10) nach einem der Ansprüche 1 bis 6.

8. Verfahren zur Herstellung einer Haushaltsgerätevorrichtung (10), **dadurch gekennzeichnet, dass** eine Wärmeverteilungsplatte (16) auf einer ersten Oberseite (18) eines ersten SMD-Bauelements (12) und auf einer zweiten Oberseite (20) eines zweiten SMD-Bauelements (14) befestigt wird.

9. Verfahren nach Anspruch 8, **dadurch gekennzeichnet, dass** das erste SMD-Bauelement (12) und das zweite SMD-Bauelement (14) mit der auf der ersten Oberseite (18) und auf der zweiten Oberseite (20) befestigten Wärmeverteilungsplatte (16) auf einer Leiterplatte (36) montiert werden.

10. Verfahren nach Anspruch 8 oder 9, **dadurch gekennzeichnet, dass** auf einer dem ersten SMD-Bauelement (12) und dem zweiten SMD-Bauelement (14) abgewandten Seite (40) der Wärmeverteilungsplatte (16) zumindest ein Kühlkörper (38) befestigt wird.
